# EUROPÄISCHE PATENTANMELDUNG

(11) **EP 1 094 130 A2**
(43) Veröffentlichungstag der Anmeldung: **25.04.2001**
(21) Anmeldenummer: 00117039.8
(22) Anmeldetag: 09.08.2000
(51) Int. Cl.: C23C 16/503, C23C 16/517

(54) **Verfahren und Vorrichtung zur Plasmabehandlung von Oberflächen**

(30) Priorität: 22.10.1999 DE 19951017
(71) Anmelder: ROBERT BOSCH GMBH, 70442 Stuttgart (DE)
(72) Erfinder: Forget-Funk, Jeanne, Mountain View, CA 94041 (US); Voigt, Johannes, 71229 Leonberg (DE)

(57) **Zusammenfassung**

Bei einem Verfahren zum Behandeln und Beschichten einer Oberfläche eines Werkstücks (8) mit einem Plasma, bei dem ein alternierendes elektrisches Feld zwischen dem Werkstück (8) und einer ersten Plasmaelektrode (4) erzeugt wird, um aus der Richtung des zugeordneten Plasmas (7) abwechselnd Ionen und Elektronen auf die Oberfläche zu lenken, ist vorgesehen, daß das Werkstück den Ionen und Elektronen in einem Zwischenraum zwischen der ersten und wenigstens einer weiteren Plasmaelektrode (5) ausgesetzt wird, und daß zwischen jeder der weiteren Plasmaelektroden (5) und dem Werkstück (8) ebenfalls ein alternierendes elektrisches Feld erzeugt wird, und die alternierenden Felder aller Plasmaelektroden (4,5) jeweils in einem festen Phasenverhältnis zueinander stehen. Auf diese Weise bilden sich auf jeder Oberfläche des Werkstücks zyklisch sowohl negative wie positive Potentiale. Diese führen abwechselnd zum positiven Ionenbombardement der Oberfläche und zu Neutralisation durch Elektronen der dadurch entstehenden Oberflächenladung.

## Beschreibung

Die vorliegende Erfindung betrifft ein Verfahren und eine Vorrichtung zum Behandeln der Oberfläche eines Werkstücks mit einem Plasma, bei dem ein alternierendes elektrisches Feld zwischen einem Werkstück und einer ersten Plasmaelektrode erzeugt wird, um alternierend aus der Richtung des Plasmas Ionen und Elektronen auf die Oberfläche zu lenken.

Derartige Verfahren und Vorrichtungen kommen insbesondere bei der Erzeugung von PVD-/PECVD-Schichten auf Werkstücken sowie bei der Vorbehandlung dieser Werkstücke vor der Abscheidung solcher Schichten zum Einsatz.

So kann zum Beispiel vor einem eigentlichen Beschichtungsschritt die Oberfläche von zu beschichtenden Teilen einem Plasmaätzschritt unterworfen werden, der die Oberfläche mikroskopisch von Verunreinigungen befreit und reinigt und zudem durch Erzeugen von freien Bindungen die Oberfläche aktiviert. Es ist bekannt, daß dieser Effekt durch das Anlegen einer negativen Vorspannung (bias) an die zu bearbeitenden Werkstücke deutlich verstärkt wird und daß die Anwendung einer solchen Vorspannung auch zu einer verbesserten Haftfestigkeit von später auf diesen Oberflächen erzeugten Schichten führt. Es ist ebenfalls verbreitet, an das zu beschichtende Werkstück während der Abscheidung von Beschichtungen ein negatives elektrisches Potential (Biaspotential) anzulegen. Dies bewirkt ein verstärktes Bombardement der aufwachsenden Schichten mit elektrisch positiv geladenen Ionen, was zu einer erwünschten Kompaktierung und Härtung der aufwachsenden Schichten führt.

Die Wirksamkeit einer solchen Plasmabehandlung kann insbesondere bei elektrisch nichtleitenden Werkstücken empfindlich dadurch beeinträchtigt werden, daß das Bombardement mit den positiv geladenen Ionen zu einer positiven statischen Aufladung der zu behandelnden Oberflächen führt. Diese statische Aufladung verringert die Energie, mit der die Ionen auf die Oberfläche treffen und führt, wenn das statische Potential schließlich einen der Ionenenergie entsprechenden Wert erreicht, zum Erliegen des Ionenbeschusses.

Es sind daher verschiedene Lösungen entwickelt und vorgeschlagen worden, um einen kontinuierlichen Ionenbeschuß auch von elektrisch nichtleitenden Oberflächen wie etwa Kunststoffoberflächen zu ermöglichen.

Einem ersten Ansatz zufolge wird eine Oberfläche, bevor mit dem Abscheiden der gewünschten Schichten auf ihr begonnen wird, zunächst metallisiert und dann an die Metallschicht ein elektrischer Kontakt angelegt, so daß während der Beschichtung eine Vorspannung angelegt und die Werkstückoberfläche auf einem gegebenen Potential gehalten werden kann. Ein solches Verfahren ermöglicht aber keinen biasunterstützen Plasmaätzschritt, was zu einer Beeinträchtigung der Haftfestigkeit der Beschichtung führen kann.

Ein zweiter Ansatz, der inbesondere bei flachen Werkstücken verfolgt wird, ist, diese direkt auf eine Elektrode aufzulegen, so daß eine an die Elektrode angelegte negative Vorspannung durch das Isolatormaterial des Werkstücks durchgreift und so zu einem verstärkten Ionenbeschuß führt. Um die Bildung von statischen Oberflächenladungen zu vermeiden, die die negative Vorspannung bereits nach kurzer Zeit neutralisieren würden, muß mit einer bipolaren, gepulsten oder sinusförmigen Biasspannung gearbeitet werden. Hierdurch wird die Werkstückoberfläche zyklisch wechselnd mit Ionen und mit Elektronen bombardiert. Dieses Vorgehen ermöglicht gute Schichthaftfestigkeiten und kompakte, hochwertige Funktionsschichten.

Für Werkstücke mit nicht vernachlässigbaren Abmessungen in allen drei Raumrichtungen ist dieser Ansatz jedoch nicht anwendbar, da der kapazitive Durchgriff der Biasspannung durch das Werkstück abhängig von der lokalen Dicke des zu beschichtenden Werkstücks ist. Unterschiede im effektiven lokalen Potential der dem Ionenstrom ausgesetzten Oberfläche können daher zu lokalen Inhomogenitäten der Schichtqualität führen.

Zudem ist es für diesen Ansatz notwendig, geeignete Elektroden zu verwenden, die an die zu beschichtenden Werkstücke präzise formangepaßt sind und mit diesen passungsbündig kontaktiert werden müssen. Andernfalls könnte in dem Spalt zwischen Werkstück und Elektrode sich eine elektrische Entladung ausbilden. Diese Notwendigkeit von formangepaßten Elektroden macht das Verfahren offensichtlich kostspielig und beschwerlich in der Anwendung. Außerdem sind zur vollständigen Beschichtung eines Werkstücks immer wenigstens zwei Behandlungsschritte erforderlich, da die Oberfläche, an der das Werkstück an der Elektrode anliegt, nicht behandelt werden kann.

### Vorteile der Erfindung

Durch die Erfindung werden ein Verfahren und eine Vorrichtung für die Plasmabehandlung von Oberflächen geschaffen, die eine schnelle Behandlung von Werkstücken von weitgehend beliebiger Form mit Mitteln gestatten, die nicht an die konkrete Form des Werkstücks angepaßt zu werden brauchen.

Diese Vorteile werden zum einen bei einem Verfahren nach dem Oberbegriff des Anspruchs 1 dadurch erreicht, daß das Werkstück den Ionen und Elektronen in einem Zwischenraum zwischen der ersten und wenigstens einer weiteren Plasmaelektrode ausgesetzt wird, und daß zwischen jeder der weiteren Plasmaelektroden und dem Werkstück ebenfalls ein alternierendes elektrisches Feld erzeugt wird, wobei die alternierenden Felder aller Plasmaelektroden jeweils in einem festen Phasenverhältnis zueinander stehen. Jede Plasmaelektrode ist einem anderen Oberflächenbereich des Werkstücks zugewandt und befindet sich abwechselnd auf positivem und negativem Potential, so daß die zugewandte Oberfläche des zu beschichtenden Werkstücks aus dem Plasma der Elektrode heraus alternierend mit Elektronen und Ionen beschossen wird. Da die Elektroden sich in einem Abstand vom Werkstück befinden, machen sich Unterschiede im kapazititven Durchgriff der Felder durch das Werkstück je nach lokaler Dicke des Werkstücks nur noch eingeschränkt bemerkbar.

Vorzugsweise wird das elektrische Feld am zu beschichtenden Werkstück allein durch Anlegen von wechselnden Potentialen an die Plasmaelektroden erzeugt. Das Werkstück selber liegt nicht auf einem festen Potential, sondern sein Potential stellt sich in Abhängigkeit von den Elektronen- beziehungsweise Ionenflüssen auf seiner Oberfläche ein. Insbesondere kann es mit der an den Plasmaelektroden anliegenden Frequenz seine Polarität wechseln.

Vorzugsweise werden für die Behandlung n Plasmaelektroden eingesetzt, die auf einem Kreis um das Werkstück angeordnet sind. Das Phasenverhältnis der alternierenden Felder benachbarter Elektroden beträgt dann vorzugsweise zwei 2πm/n. Unter diesen Bedingungen ist das zeitlich mittlere elektrische Potential in der Umgebung des im wesentlichen mittig zwischen den Plasmaelektroden angeordneten Werkstücks im wesentlichen nahe dem Endpotential, ohne daß es dafür notwendig wäre, das Werkstück an ein externes Endpotential anzuschließen.

Bei einer einfachen Ausgestaltung des Verfahrens, bei der lediglich zwei Plasmaelektroden zum Einsatz kommen, liegen sich diese beiderseits des Zwischenraumes gegenüber und können jeweils gegenphasig betrieben werden.

Um Abweichungen des elektrischen Potentials des Werkstücks vom Wert Null aufgrund elektrostatischer Aufladung bei empfindlichen Werkstückmaterialien gering zu halten, wird die Frequenz der alternierenden Felder ausreichend hoch gewählt. Typische Werte der Frequenz liegen im Bereich zwischen 1 KHz und 350 MHz, wobei um so höhere Frequenzen erforderlich sind, je stärker die Ionen- beziehungsweise Elektronenflüsse auf das Werkstück sind.

Im Anschluß an eine nach dem erfindungsgemäßen Verfahren durchgeführte Aktivierung einer Werkstückoberfläche durch Ionenbeschuß kann diese beschichtet, bedruckt, verklebt oder lackiert werden.

Es kann auch zeitgleich mit der geschilderten Plasma-Behandlung des Werkstücks ein schichtbildendes Material auf dem Werkstück abgeschieden werden, indem es in der Umgebung des Werkstücks verdampft oder zerstäubt wird.

Diese Verdampfung oder Zerstäubung kann auf einfache Weise erreicht werden, indem das schichtbildende Material dem Einfluß des Plasmas ausgesetzt wird, oder indem es in einem Schiffchen oder einer Knudsen-Zelle unabhängig vom Plasma erhitzt wird.

Die zu behandelnden Werkstücke können in einer Behandlungsvorrichtung stationär gehaltert sein, bevorzugt ist allerdings, sie kontinuierlich durch eine solche Vorrichtung hindurchzuführen.

Das Verfahren eignet sich auch zur Niedertemperaturbeschichtung, so daß gehärteter Stahl ohne Härteverluste und bei hinreichend geringer Leistungsdichte auch Kunststoffe beschichtet werden können.

Weitere Merkmale und Vorteile der Erfindung ergeben sich aus der nachfolgenden Beschreibung von Ausführungsbeispielen mit Bezug auf die beigefügte Figur.

### Figuren

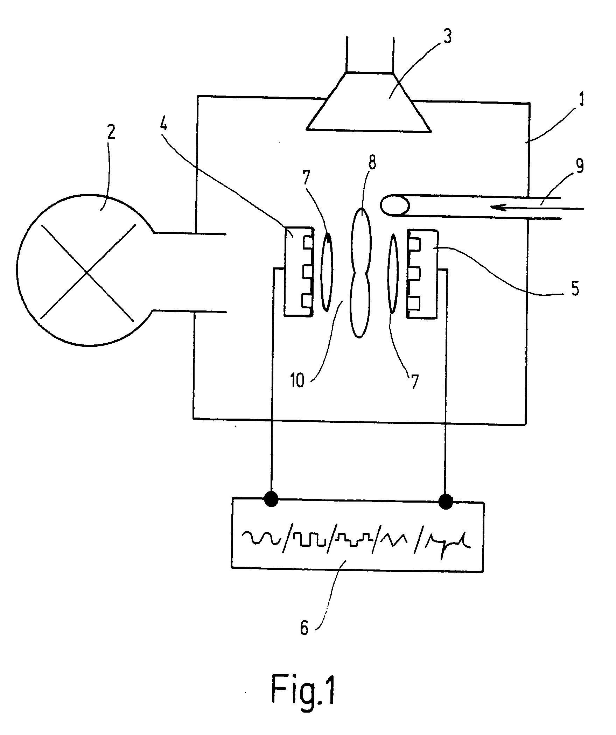

Die Figuren 1 bis 3 zeigen jeweils stark schematisiert Ausgestaltungen einer Vakuumapparatur für die Plasmabehandlung eines Werkstücks.

### Beschreibung von Ausführungsbeispielen

Die in der Figur 1 gezeigte Vakuumapparatur umfaßt eine Vakuumkammer 1 mit einer daran angeschlossenen Pumpe 2 und einer Mikrowellenquelle 3. Die Magnetfeldstärke der Permanentmagneten der Plasmaelektroden sind derart ausgelegt, daß ECR (Elektron-Zyklotron-Resonanz) auftritt. An den Plasmaelektroden brennt daher bei Einstrahlung von Mikrowelle in die Vakuumkammer ein Plasma. Über die Stärke der eingekoppelten Mikrowellenstrahlung ist die Plasmadichte steuerbar.

Die Plasmaelektroden 4,5 sind im Zentrum der Vakuumkammer 1 einander zugewandt angeordnet und mit Anschlußklemmen einer Wechselspannungsversorgung 6 verbunden. Sie versorgt die Plasmaelektroden 4,5 mit einer alternierenden Wechselspannung. Die Frequenz der Wechselspannung liegt im Bereich von 1 KHz bis ca. 50 MHz. Ihr zeitlicher Verlauf kann zum Beispiel sinusförmig, rechteckförmig mit oder ohne Pausen zwischen entgegengesetzten Rechteckpulsen, dreieck- oder sägezahnförmig oder dergleichen sein, wie durch die in das Symbol der Wechselspannungsversorgung in der Figur eingezeichneten Symbole angedeutet. Die zwischen den Elektroden 4,5 anliegende Spannung beträgt einige hundert Volt und wird in Abhängigkeit vom Material eines zu bearbeitenden Werkstücks 8 beziehungsweise vom Material der aufzubringenden Beschichtung gewählt.

Das Werkstück 8 ist im wesentlichen mittig zwischen den zwei Elektroden 4,5 angeordnet. Es kann in dieser Stellung stationär gehalten sein oder auch im Laufe seiner Behandlung kontinuierlich durch den Zwischenraum 10 zwischen den Elektroden 4,5 hindurchbewegt werden. Ein Plasma 7 wird an jeder Elektrode 4,5 während der gesamten Dauer der Behandlung des Werkstücks 8 und unabhängig von der momentanen Polarität des an die zugeordnete Elektrode 4 oder 5 durch die Wechselspannungsversorgung 6 angelegten Potentials aufrechterhalten.

Auf diese Weise wird zu einem gegebenen Zeitpunkt eine Oberfläche des Werkstücke 8 aus dem Plasma 7 der positiven Elektrode 4 oder 5 mit Ionen und die gegenüberliegende Oberfläche aus dem Plasma der anderen Elektrode 5 beziehungsweise 4 mit Elektronen beschossen. Eine eventuelle positive Aufladung der dem Ionenstrom ausgesetzten Seite des Werkstücks wird weitgehend kompensiert durch eine entgegengesetzte Aufladung der Oberfläche durch den Elektronenstrom während der nächsten Halbwelle, und umgekehrt,

Die chemische Zusammensetzung des Plasmas 7 hängt selbstverständlich von der Art des Prozeßgases ab, das durch eine Gasversorgung 9 in die Vakuumkammer 1 eingespeist wird.

Als Gase für eine Oberflächenaktivierung des Werkstücks 8 werden zum Beispiel Argon, Helium, Neon, Sauerstoff, Stickstoff, Wasserstoffperoxid, Wasserstoff, Ammoniak oder Halogenide beziehungsweise deren Mischungen eingesetzt, abhängig von dem Material der Werkstücke und dem zu erreichenden Oberflächenzustand.

Wenn die Plasmabehandlung eine Beschichtungsbehandlung der Werkstücke umfaßt, werden als Prozeßgas vorteilhaft Kohlenwasserstoffe, Siliziumverbindungen, organische Verbindungen sowie Metallorganika verwendet. Mit diesen Prozeßgasen können Schichten bei Temperaturen von 200°C oder darunter abgeschieden werden. Wenn bei ausreichender Temperaturfestigkeit des Werkstücks 8 höhere Prozeßtemperaturen möglich sind, können weitere Gase, etwa Halogenide, zum Beispiel TiCl₄, verwendet werden. Diese Gase können einzeln oder als Gemisch eingesetzt werden und auch mit Reaktivgasen wie zum Beispiel Sauerstoff, Stickstoff, Wasserstoffperoxyd, Wasserstoff, Ammoniak und/oder Inertgasen wie Argon, Helium, Neon, Krypton, gemischt werden. Je nach Gasmischung ergeben sich unterschiedliche Schichtsysteme.

Die Plasmaelektroden 4,5 können in unterschiedlicher Weise augestaltet sein. Gemäß einer ersten Variante kann es sich um Plasmaelektroden handeln, die ausschließlich die Gasphase in der Vakuumkammer I aktivieren. Beispiele für diesen Fall sind Mikrowellen-ECR-Quellen oder HF-Quellen, die bei 13,56 oder 27 MHz eigenständig Plasmen an den Quellen erzeugen. Analog können dann statt der Mikrowelle Hochfrequenzfelder auf geeignete resonante Elektroden eingestrahlt werden oder direkt eine HF-Leistung an die Elektroden angelegt werden.

Die Plasmaelektroden können ferner derart ausgeführt werden, daß an den Elektroden zusätzlich festes Material zerstäubt oder verdampft wird, das sodann während der Behandlung des Werkstücks als schichtbildendes Material zur Verfügung steht. In diesem Fall sind Magnetron-Sputterquellen oder Hohlkathoden geeignet, die mit Gleichspannung oder gepulst oder bei Mittelfrequenz bei einigen Kilohertz mit sinus- oder rechteck- oder dreieckförmigen Spangen oder bei 13,56 oder 27 MHz betrieben werden und ein eigenständiges Plasma erzeugen. Es können auch Arc-Quellen verwendet werden, die mit Gleichspannung oder gepulst betrieben werden.

Es können auch Elektroden eingesetzt werden, die kein eigenständiges Plasma erzeugen und eine zusätzliche, externe Plasmaanregung benötigen. Beispiele hierfür sind Elektroden mit Gleichspannungs-Glimmentladung, die über zusätzliche Elektronenemitter gespeist werden.

Bei Bedarf können auch weitere Verdampferquellen in der Vakuumkammer 1 vorgesehen werden, die zusätzliches schichtbildendes Material zur Verfügung stellen, so etwa beheizbare Schiffchen, Knudsenzellen oder Elektronenstrahlverdampfer. Die oben genannten unterschiedlichen Bauformen von Elektroden und Quellen für schichtbildendes Material können im Prinzip beliebig kombiniert und auch im Wechsel betrieben werden, um Schichten mit variabler Zusammensetzung auf dem Werkstück zu erzeugen.

Für eine praktische Anwendung des erfindungsgemäßen Verfahrens wurde Kautschuk-Flachmaterial als Werkstück 8 zwischen zwei MW-ECR-Magnetron-Elektroden 4,5 positioniert. Die Elektroden 4,5 wurden mit einer Wechselspannung von 13,56 MHz mit ca. 200 Watt von der Spannungsversorgung 6 beaufschlagt. Der Abstand zwischen den Magnetbänken der Magnetronelektroden und dem Werkstück 8 betrug jeweils ca. 4 cm.

In einem ersten Verfahrensschritt wurde eine Aktivierung der Werkstückoberfläche durchgeführt, wozu als Prozeßgas Argon und O₂ mit einem Gasfluß von 5 und 20 sccm über eine sich in Form eines Rahmens entlang der Elektroden 4,5 erstreckende Gasversorgung 9 eingelassen wurden. Der Druck in der Vakuumkammer 1 betrug 2 x 10⁻³ Millibar. Die über die Mikrowellenquelle 3 eingekoppelte Mikrowellenleistung betrug 0,5 Kilowatt. Die an die Elektroden 4,5 angelegte Wechselspannung betrug 200 Volt. Die Oberfläche des Werkstücks 8 wurde geätzt und aktiviert.

In einem zweiten Schritt wurde als Prozeßgas C₂H₂ mit einem Gasfluß von 60 sccm über die Gasversorgung 9 entlang der Elektroden 4,5 eingelassen. Der Druck in der Vakuumkammer betrug 4 x 10⁻³ Millibar. Die eingekoppelte Mikrowellenleistung betrug 0.5 Kilowatt, die Spannung an den Elektroden 4,5 war 400 Volt. Auf der Oberfläche wurde eine biege- und haftfeste amorphe, diamantähnliche Kohlenstoffschicht (DLC) erhalten.

Die Trockenreibung der Schicht gegen Stahl betrug 0,1 bis 0,2, ähnlich wie bei hochwertigen DLC-Schichten, die in konventionellen, direkt gebiasten Verfahren auf metallischen Substraten abgeschieden werden.

Die Ergebnisse zeigen, daß mit dem erfindungsgemäßen Verfahren qualitativ hochwertige Schichten mit hoher Haft- und Verschleißfestigkeit abgeschieden werden, ohne daß dafür eine Biasspannung direkt an das zu beschichtende Werkstück angelegt werden muß. Die Beschichtungstemperatur betrug lediglich 100°C, was das Verfahren auch zur Aktivierung und Beschichtung von Kunststoffwerkstücken ohne weiteres geeignet macht.

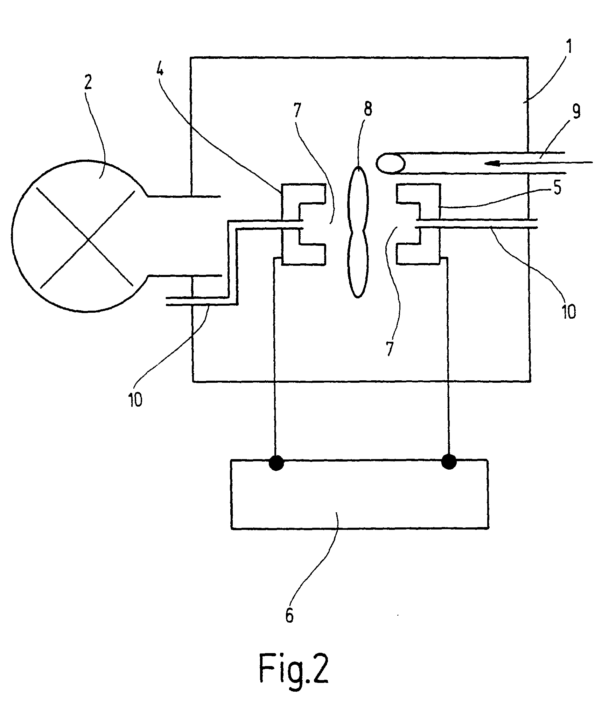

Eine alternative Anwendung zeigt Figur 2. Das Werkstück 8 wird zwischen zwei Hohlkathoden 4,5 positioniert. An den Hohlkathoden werden Plasmen gezündet, indem an diese eine alternierende Spannung angelegt wird. Die alternierende Spannung wird von einer Spannungsversorgung 6 entsprechend der mit Bezug auf Figur 1 beschriebenen geliefert. Im Plasma innerhalb der Hohlkathode 4 beziehungsweise 5 wird Prozeßgas angeregt, das durch eine in den Hohlraum der Hohlkathode mündende Rohrleitung 10 zugeführt wird. Eine Mikrowellenquelle wie mit Bezug auf Figur 1 beschrieben ist bei dieser Ausgestaltung nicht erforderlich, um das Plasma zu zünden und in Gang zu halten. Die Gasversorgung 9, die Prozeßgas frei in die Vakuumkammer 1 austreten läßt, kann bei Verwendung der Rohrleitungen 10 unter Umständen entfallen. Bei entsprechenden Spannungen kann auch Material, was zur Schichtbildung beiträgt, abgesputtert werden.

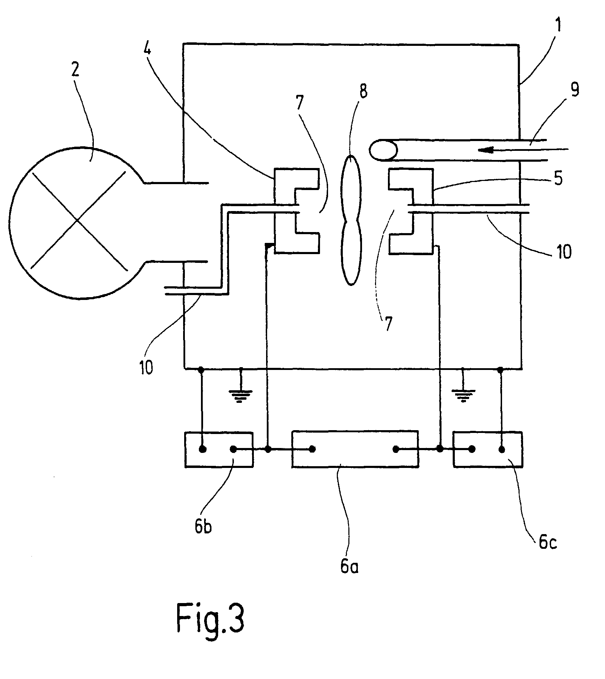

Eine optimierte Variante von Figur 2 zeigt Figur 3, in der die Plasmaerzeugung in den Hohlkathoden 4,5 unabhängig von der zwischen den Hohlkathoden angelegten alternierenden Spannung erfolgt. Das Plasma in den Hohlkathoden wird durch eigenständige DC- oder HF-Netzteile 6b,6c gezündet und betrieben. Dies gestattet eine von der zwischen den Hohlkathoden anliegenden, von der Spannungsversorgung 6a gelieferten alternierenden Spannung unabhängige Einstellung der Plasmadichte und der Betriebsparameter der Hohlkathoden, was größere Freiheiten in der Wahl der Prozeßführung erlaubt und eine bessere Oberflächenbehandlung beziehungsweise Beschichtung der Werkstücke erlaubt.

Alternativ zu den Hohlkathoden können auch die vorne erwähnten anderen Plasmaelektroden wie Sputterquellen und HF-Quellen mit unabhängigen Netzgeräten eingesetzt werden und weitere vorne erwähnte Verdampferquellen kombiniert werden.

## Patentansprüche

1. Verfahren zum Behandeln einer Oberfläche eines Werkstücks (8) mit einem Plasma, bei dem ein alternierendes elektrisches Feld zwischen dem Werkstück (8) und einer ersten Plasmaelektrode (4) erzeugt wird, um alternierend aus der Richtung des der Plasmaelektrode (4) zugeordneten Plasmas (7) Ionen und Elektronen auf die Oberfläche zu lenken, **dadurch gekennzeichnet,** daß das Werkstück (8) den Ionen und Elektronen in einem Zwischenraum (10) zwischen der ersten (4) und wenigstens einer weiteren Plasmaelektrode (5) ausgesetzt wird, und daß zwischen jeder der weiteren Plasmaelektroden (5) und dem Werkstück (8) ebenfalls ein alternierendes elektrisches Feld erzeugt wird und die alternierenden Felder der Plasmaelektroden (4,5) jeweils in einem festen Phasenverhältnis zueinander stehen.

2. Verfahren nach Anspruch 1, **dadurch gekennzeichnet,** daß das elektrische Feld durch Anlegen von Wechselpotentialen allein an die Plasmaelektroden (4,5) erzeugt wird.

3. Verfahren nach Anspruch 1 oder 2, **dadurch gekennzeichnet,** daß n Plasmaelektroden (4,5) eingesetzt werden, wobei das Phasenverhältnis der alternierenden Felder benachbarter Elektroden 2πm/n ist, mit m<n und m und n ganzzahlig.

4. Verfahren nach Anspruch 3, **dadurch gekennzeichnet,** daß zwei Plasmaelektroden (4,5) eingesetzt werden, die einander beiderseits des Zwischenraums (10) gegenüberliegen.

5. Verfahren nach einem der vorhergehenden Ansprüche, **dadurch gekennzeichnet,** daß die Felder mit einer Frequenz zwischen 1 KHz und 350 MHz alternieren.

6. Verfahren nach einem der vorhergehenden Ansprüche, **dadurch gekennzeichnet,** daß das Werkstück mit im wesentlichen gleichen Abständen zu den Plasmaelektroden (4,5) in dem Zwischenraum (10) angeordnet wird.

7. Verfahren nach einem der vorhergehenden Ansprüche, **dadurch gekennzeichnet,** daß das Werkstück (8) aus elektrisch nichtleitendem Material besteht.

8. Verfahren nach einem der vorhergehenden Ansprüche, **dadurch gekennzeichnet,** daß im Anschluß an die Plasmabehandlung des Werkstücks (8) die Oberfläche des Werkstücks (8) beschichtet, bedruckt, verklebt oder lackiert wird.

9. Verfahren nach einem der vorhergehenden Ansprüche, **dadurch gekennzeichnet,** daß zeitgleich mit der Plasma-Behandlung des Werkstücks (8) ein schichtbildendes Material in der Umgebung des Werkstücks (8) verdampft oder zerstäubt wird.

10. Verfahren nach Anspruch 9, **dadurch gekennzeichnet,** daß die Verdampfung oder Zerstäubung erfolgt, indem das schichtbildende Material dem Einfluß des Plasmas (7) ausgesetzt wird.

11. Verfahren nach einem der vorhergehenden Ansprüche, **dadurch gekennzeichnet,** daß jeder Plasmaelektrode (4,5) ein unabhängiges Netzgerät (6b,6c) zugeordnet ist und die Plasmadichte an einer der Plasmaelektroden mit Hilfe des zugeordneten Netzgeräts (6b,6c) eingestellt wird.

12. Verfahren nach einem der Ansprüche 1 bis 10, **dadurch gekennzeichnet,** daß die Plasmadichte an den Plasmaelektroden durch Einstrahlen von Mikrowellen- oder Hochfrequenzstrahlung auf die Plasmaelektroden geregelt wird.

13. Verfahren nach einem der vorhergehenden Ansprüche, **dadurch gekennzeichnet,** daß nach und/oder während der Plasmabehandlung wenigstens eine kohlenstoff- und/oder siliziumhaltige Schicht auf der Oberfläche des Werkstücks (8) abgeschieden wird.

14. Vorrichtung zum Behandeln einer Oberfläche eines Werkstücks (8), mit einer Vakuumkammer (1), in der das Werkstück in einer Behandlungsposition plazierbar ist, und die eine erste Plasmaelektrode (4) umfaßt, die mit einem alternierenden Biaspotential zum Erzeugen eines alternierenden elektrischen Feldes zwischen der Plasmaelektrode (4) und dem Werkstück (8) beaufschlagbar ist, um alternierend aus der Richtung des Plasmas (7) Ionen und Elektronen auf die Oberfläche des Werkstücks (8) zu lenken, **dadurch gekennzeichnet,** daß die Behandlungsposition des Werkstücks (8) in einen Zwischenraum (10) zwischen der ersten und wenigstens einer weiteren Plasmaelektrode (5) liegt, und daß jede der weiteren Plasmaelektroden (5) mit einem alternierenden elektrischen Potential beaufschlagbar ist, wobei die Potentiale aller Plasmaelektroden (4,5) jeweils in einem festen Phasenverhältnis zueinander stehen.

15. Vorrichtung nach Anspruch 14, **dadurch gekennzeichnet,** daß das Werkstück (8) gegen die Plasmaelektroden (4,5) elektrisch isoliert ist.

16. Vorrichtung nach Anspruch 14 oder 15, **dadurch gekennzeichnet,** daß die Plasmaelektroden (4,5) auf einem Kreis gleichverteilt sind, dessen Mittelpunkt die Behandlungsposition ist.

17. Vorrichtung nach einem der Ansprüche 14 bis 16, **dadurch gekennzeichnet,** daß sie zwei Plasmaelektroden (4,5) aufweist.

18. Vorrichtung nach einem der Ansprüche 14 bis 17, **gekennzeichnet durch** eine Spannungsversorgung (6) zum Beaufschlagen der Plasmaelektroden (4,5) mit den alternierenden Potentialen.

19. Vorrichtung nach einem der Ansprüche 14 bis 18, **dadurch gekennzeichnet,** daß das Werkstück (8) durch den Zwischenraum (10) hindurchbewegbar ist.

20. Vorrichtung nach einem der Ansprüche 14 bis 19, **dadurch gekennzeichnet,** daß jeder Plasmaelektrode (4,5) ein Netzteil (6b,6c) zugeordnet ist, das die Plasmaelektrode mit einem Wechselpotential relativ zur Vakuumkammer (1) beaufschlagt.

21. Vorrichtung nach einem der Ansprüche 14 bis 20, **dadurch gekennzeichnet,** daß die Plasmaelektroden (4,5) als ECR-Elektroden ausgebildet sind, und daß zum Zünden und Aufrechterhalten des Plasmas (7) eine Mikrowellenquelle (3) vorgesehen ist.
